# EUROPEAN PATENT APPLICATION

(11) **EP 1 525 955 A2**
(43) Date of publication of application: **27.04.2005**
(21) Application number: 04077824.3
(22) Date of filing: 14.10.2004
(51) Int. Cl.: B25J 9/16, B25J 19/06, H05K 13/04

(54) **Method and device for moving an element with collision detection**

(30) Priority: 23.10.2003 EP 03103923
(71) Applicant: Assembléon N.V., 5503 LA Veldhoven (NL)
(72) Inventor: Van der Burg, Richard Adrianus Johannes, 5646 HS Eindhoven (NL)
(74) Representative: Veldman-Dijkers, Cornelia G.C., Ir.

(57) **Abstract**

Method for moving an element (8) by means of a drive system (25), the method comprising the steps of determining a difference between a predetermined, desired value of the position of the element and an actually measured value of the position of the element (8) at frequent intervals by means of a processor during the movement of the element (8), establishing that a collision of the element (8) with an object has taken place if said difference is greater than a predetermined parameter, wherein, once the occurrence of a collision has been established, the element (8) is pressed against the object in a controlled manner by means of the drive system (25) predetermined, desired period of time.

## Description

The invention relates to a method for moving an element by means of a drive system, comprising the steps of:
- determining a difference between a predetermined, desired value of the position of the element and an actually measured value of the position of the element at frequent intervals by means of a processor during the movement of the element,
- determining that a collision of the element with an object has taken place if said difference is greater than a predetermined parameter.

The invention also relates to a device suitable for carrying out such a method.

With such a method and device as known from European patent EP-B1-0 365 681, a parameter depending on the driving force of the servo motor is detected at frequent intervals, and it is assumed that a collision has occurred if said parameter exceeds a predetermined value. As soon as the occurrence of a collision has been established, measures are taken, such as stopping the servo motor in order to prevent damage being caused to the machine by the collision or limit the extent of any such damage.

The object of the invention is to provide a method wherein different measures are taken after the occurrence of a collision has been established.

This object is achieved with the method according to the invention in that, once the occurrence of a collision has been established, the element is pressed against the object in a controlled manner by means of the drive system for a predetermined, desired period of time.

In this way it is possible to press the element against the object as soon as or after the occurrence of a collision has been established. As a result, the element can be pressed against the object without causing damage to the element or to the object, for example in order to ensure that the element is positioned on the object at a desired position or is connected to the object at the desired position, for example by means of a glued joint.

Such a method is in particular suitable for use with a relatively stiff drive system which cannot be compressed against spring force, or only to a small extent.

One embodiment of the method according to the invention is characterized in that a force with which the element is pressed against the object is maintained at a predetermined value by means of the processor.

In this way it is possible to press the element against the object with a constant force, for example, thus making it possible to effect a strong and detachable, if desired, connection between the element and the object.

Another embodiment of the method according to the invention is characterized in that the element is initially moved towards the object at a relatively high velocity during the movement of the element towards the object, whilst the element is moved at a relatively low velocity upon approaching the object.

Thus it is possible to move the element towards the object at a relatively high velocity, and as a result of the relatively low velocity of the object upon approaching the object, the forces that occur upon collision between the element and the object will be relatively small. Subsequently it is possible to press the element against the object with the relatively low force that occurs upon said collision. Thus, no large variations in the forces being exerted on the element or on the object will occur.

Yet another embodiment of the method according to the invention is characterized in that the element comprises a component pick-up unit, which is provided with a nozzle, in which nozzle a vacuum for picking up a component is generated.

When component pick-up units are used, it is important that components can be picked up in an accurate manner, after which said components must be accurately positioned at a desired position, for example on a substrate. When a component is picked up, it is important that a temporary connection is effected between the component pick-up unit and the component without damage being caused to the component pick-up unit or to the component. The method according to the invention makes it possible to move the component pick-up unit to the component at a relatively high velocity, and after the occurrence of a collision has been established, press the component pick-up unit against the component to be picked up, so that a reliable temporary connection between the component pick-up unit and the component can be effected, for example by means of a vacuum. Upon placement of the component on the substrate, the component is moved to a desired position on the substrate by means of the component pick-up unit, and after the occurrence of a collision between the component and the substrate has been established, the component is pressed against the substrate with a predetermined force, for example for effecting a connection between the component and the substrate. Once the component is pressed against the substrate, the detachable connection between the component pick-up unit and the component is broken, for example by releasing the vacuum, after which the component pick-up unit is moved away from the component.

In this way components can be picked up with a relatively high degree of accuracy and with a controlled force and subsequently be placed on a substrate.

Another object of the invention is to provide a device that is suitable for carrying out such a method, in which, after the occurrence of a collision between the element and the object has been established, other advantageous measures can be taken.

This object is accomplished with the device according to the invention in that the device comprises an element that can be moved by means of a drive system and a processor that is provided with means for comparing a desired value with an actually measured value, means for establishing that a collision between the element and an object has occurred, if the difference as determined is greater than a predetermined parameter, as well as means for pressing the element against the object in a controlled manner by means of the drive system for a predetermined period of time after the occurrence of a collision has been established.

In this way it is possible to press the element against the object in a controlled manner once the occurrence of the collision has been established.

One embodiment of the device according to the invention is characterized in that the means for comparing a desired value with an actually measured value comprise a position controller.

The position controller makes it possible to establish in a relatively simple manner that a difference is arising between the expected, desired value and the actually measured value, which is an indication that the element cannot be moved any further because it has collided with the object.

Another embodiment of the device according to the invention is characterized in that the means for pressing the element against the object comprise a force controller.

A force controller makes it possible to press the element against the object with a desired force. It is possible, for example, to supply information about the power consumption required for generating the driving force of the drive system to the force controller. In this way no additional component needs to be used for the force controller, but components that are already available in the system can be used instead.

The invention will be explained in more detail with reference to the drawing, in which:
Fig. 1 is a perspective view of a component placing device;
Fig. 2 shows a position controller of the component placing device that is shown in Fig. 1;

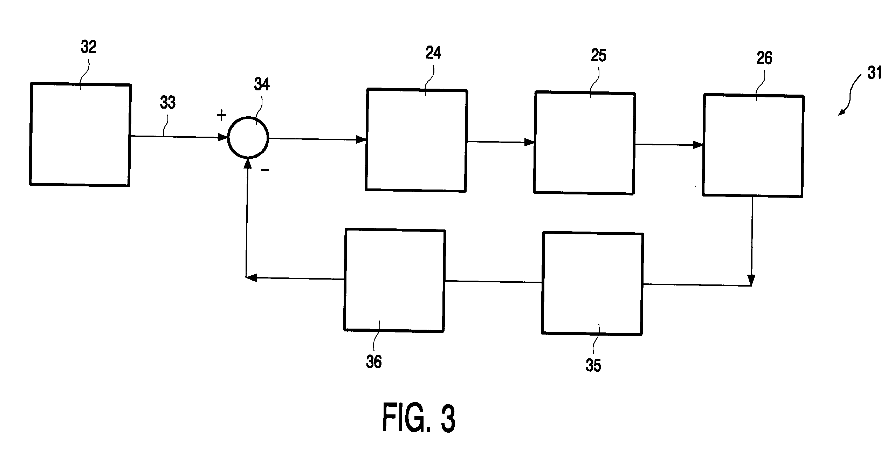

Fig. 3 shows a force controller of the component placing device that is shown in Fig. 1.

Like parts are indicated by the same numerals in the figures.

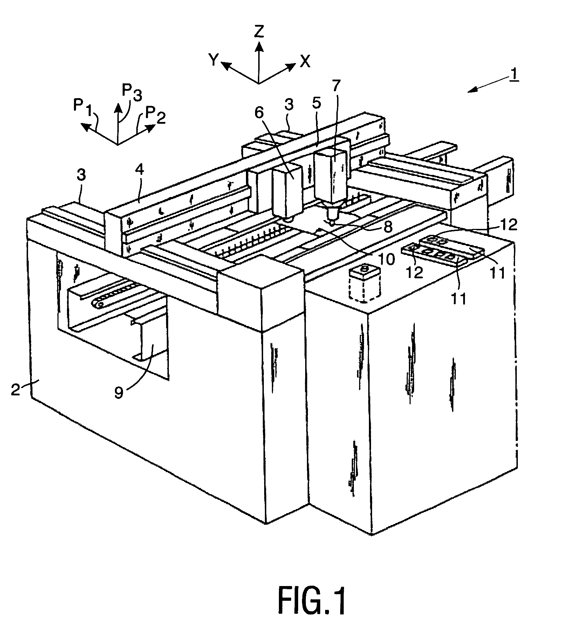

Fig. 1 shows a component placing device 1 comprising a frame 2. The frame 2 supports two rails 3, which extend parallel to each other. Said rails 3 support a guide 4 that extends transversely to the rails 3. The guide 4 can be moved over the rails 3 in the direction indicated by the arrow P1 and in the opposite direction by means of a drive system. The guide 4 supports an arm 5, which is movable over the guide 4 in the direction indicated by the arrow P2 and in the opposite direction by means of a drive system. The arm 5 supports an image recording device 6 and a component pick-up unit 7. The component pick-up unit 7 comprises a nozzle 8, in which a vacuum can be generated by vacuum means for picking up a component.

The frame 2 furthermore supports a conveying device 9, which extends parallel to the guide 4 and which is positioned under said guide 4. Substrates 10 can be moved in the direction indicated by the arrow P2 by means of the conveying device 9. The component placing machine 1 is further provided with a component supplying device 11, from which components 12 can be picked up by means of the component pick-up unit 7. The components 12 that have been picked up by means of a component pick-up unit 7 are subsequently positioned at a desired position on the substrate 10. It is possible to verify by means of the image recording device 6 whether the component pick-up unit 7 is indeed positioned above the desired position on the substrate 10. The component placing device as described so far is known per se, and will not be explained in more detail, therefore.

The component placing device 1 according to the invention further comprises a processor for controlling the drive systems of the guide 4 as well as the arm 5 in, respectively, the direction indicated by the arrow P1, parallel to the Y-direction, and the direction indicated by the arrow P2, parallel to the X-direction. The component placing device 1 is further provided with a drive system for moving the nozzle 8 with respect to the component pick-up unit 7 in the direction indicated by the arrow P3 and in the opposite direction, parallel to the Z-direction. The drive means comprise a servo motor which is provided with means from which the position of the motor can be determined.

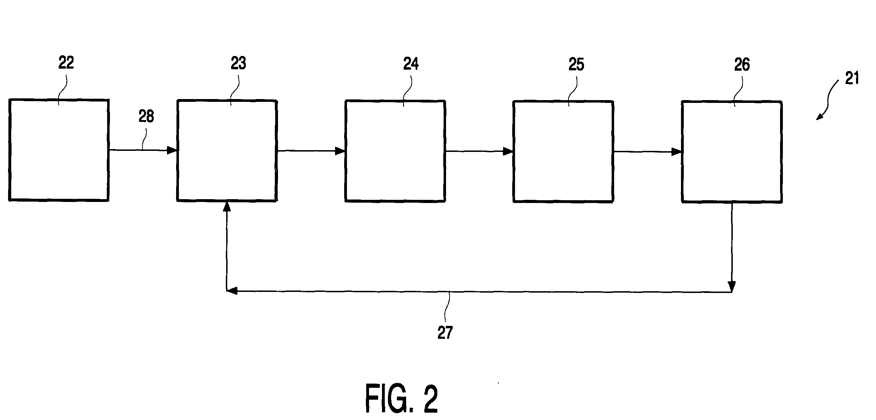

Fig. 2 shows a control diagram 21 of a processor of the component placing device 1 for controlling the movement of the nozzle 8 in the Z-direction and in the opposite direction. The control diagram 21 comprises an adjusting point generator 22, into which the desired position in the Z-direction is input. This position depends on the level at which a component 12 is expected to be present at the component supplying device 11 and, near the substrate 10, on the expected location for positioning the component. Said positions in the Z-direction may vary due to measuring inaccuracies, thickness tolerances, thermal expansions, curvatures of the substrate 10, etc. The information supplied from the generator 22 is fed to a position controller 23, which controls an amplifier 24 of the servo motor 25. A driving current for the motor 25 is generated by means of the amplifier 24, which driving current is directly proportional to the force required for the desired movement. The motor 25 is provided with a position sensor 26, by means of which the actual position of the motor and thus the actual position of the nozzle 8 is established. Said actually measured positioned 27 is compared in the position controller 23 with the desired value obtained from the generator 22, after which a desired driving current is determined by means of the amplifier 24. As soon as a difference between the expected desired value and the actually measured value in the position controller 23 exceeds a predetermined, allowable value, a relatively large driving current will be generated by means of the amplifier 24. The processor will consider such a relatively large driving current to be indicative of the occurrence of a collision between the nozzle 8 and the component 12 that is to be picked up, for example, or of a collision between the component 12 that has been picked up by means of the nozzle 8 and the substrate 10. The relatively large driving current will cause the nozzle 8 to be pressed against the object in question with a specific force.

Subsequently, a switch is made by means of the processor to the control diagram 31, by means of which the nozzle 8 is pressed against a component 12 upon picking up the component, or the nozzle 8 and a component 12 are jointly pressed against a substrate 10 upon placement of the component 8 on the substrate 10, with a predetermined force as adjusted in a force adjusting unit 32, which force is directly proportional to the driving current required for the motor 25. The desired force value 33 is fed to a comparator 34, from where a signal is passed to the amplifier 24 of the motor 25. In the position sensor 26 of the motor 25, the position of the motor and thus of the nozzle 8 are determined in a similar manner as in the control diagram 21. The information from the position sensor 26 is fed to a differentiator 35, by means of which the velocity of movement of the nozzle 8 is determined. Once the occurrence of a collision has been established, the shaft of the motor 25 must be stopped as soon as possible, which means that the desired speed of the motor must equal zero.

If the differentiator 35 detects a value deviating from zero, said value is amplified with the amplifier 36 and the value thus obtained is fed to the comparator 34 for reducing the driving current generated by means of the amplifier and thus reduce the force exerted by means of the motor 25.

Said force is used for pressing the nozzle against the object in question for a predetermined period of time.

In this way the nozzle 8 is pressed against the component 12 to be picked up or against the substrate 10 with a desired force for a predetermined, desired period of time. When a component 12 is picked up by means of the nozzle 8, the vacuum is turned on as soon as or just after the occurrence of a collision has been established, so that the component 12 is sucked against the nozzle 8. Upon placement of the component 12 on the substrate 10, the vacuum in the nozzle 8 is released in a similar manner after the occurrence of the collision has been established, so that the nozzle 8 can be moved away from the substrate 10, with the component 12 remaining behind at the desired position on the substrate 10.

As long as the nozzle 8 is present at a relatively large distance from a component 12 to be picked up or from the desired position on the substrate 10, the nozzle 8 can be moved at a relatively high velocity, which may be a constant velocity. As soon as the nozzle 8 is present relatively close to the component 8 to be picked up or the desired position on the substrate 10, the velocity of movement of the nozzle 8 is reduced, so that the force of the collision between the nozzle 8 and the component to be picked up or the substrate is relatively limited, preferably equal to the force with which the nozzle 8 is to be pressed against the component to be picked up or the substrate.

It is also possible to provide the nozzle with other means for picking up a component, such as a gripper, an electromagnet, etc.

## Claims

1. A method for moving an element (8) by means of a drive system (25), comprising the steps of:
- determining a difference between a predetermined, desired value of the position of the element and an actually measured value at frequent intervals by means of a processor during the movement of the element (8),
- establishing that a collision of the element (8) with an object has taken place if said difference is greater than a predetermined parameter, **characterized in that**, once the occurrence of a collision has been established, the element (8) is pressed against the object in a controlled manner by means of the drive system (25) for a predetermined, desired period of time.

2. A method according to claim 1, **characterized in that** a force with which the element (8) is pressed against the object is maintained at a predetermined value by means of the processor.

3. A method according to claim 1 or 2, **characterized in that** the element (8) is initially moved towards the object at a relatively high velocity during the movement of the element (8) towards the object, whilst the element (8) is moved at a relatively low velocity upon approaching the object.

4. A method according to any one of the preceding claims, **characterized in that** the element (8) comprises a component pick-up unit, which is provided with a nozzle (8), in which nozzle a vacuum for picking up a component (12) is generated.

5. A method according to claim 4, **characterized in that** the object comprises a component (12) to be picked up, wherein the vacuum is turned on for enabling the nozzle (8) to pick the component (12) as soon as or after the occurrence of a collision between the nozzle (8) and the component (12) to be picked up has been established.

6. A method according to claim 4, **characterized in that** the object comprises a substrate (10), on which a component (12) is to be positioned, whilst the element (8) comprises the component pick-up unit, the nozzle (8) as well as a component (12) picked up by means of the nozzle (8) by means of a vacuum, which vacuum is released as soon as or just after the occurrence of a collision between the component (12) and the substrate (10) has been established.

7. A method according to any one of the preceding claims, **characterized in that** the component pick-up unit and the nozzle (8) are moved away from the substrate (10) after the expiry of the predetermined period of time during which the component is pressed against the substrate (10).

8. A method according to any one of the preceding claims, **characterized in that** the predetermined value of the force with which the element (8) is pressed against the object is adjustable.

9. A device suitable for carrying out the method according to any one of the preceding claims, **characterized in that** the device comprises an element (8) that can be moved by means of a drive system (25) and a processor that is provided with means for comparing a desired value with an actually measured value, means for establishing that a collision between the element (8) and an object has occurred if the difference as determined is greater than a predetermined parameter, as well as means for pressing the element (8) against the object in a controlled manner by means of the drive system (25) for a predetermined period of time after the occurrence of a collision has been established.

10. A device according to claim 9, **characterized in that** the means for comparing a desired value with an actually measured value comprise a position controller.

11. A device according to claim 9 or 10, **characterized in that** the means for pressing the element (8) against the object comprise a force controller.

12. A device according to any one of the preceding claims 9-11, **characterized in that** the element (8) comprises a component pick-up unit, which is provided with a nozzle (8) in which a vacuum can be generated for picking up a component (12), whilst the object is a substrate (10) on which the component (12) can be positioned.
